# EUROPEAN PATENT APPLICATION

(11) **EP 3 493 242 A1**
(43) Date of publication of application: **05.06.2019**
(21) Application number: 17833791.1
(22) Date of filing: 15.05.2017
(51) Int. Cl.: H01L 21/02, B23K 20/00, B23K 20/24, H01L 21/302, H01L 21/3065

(54) **SUBSTRATE JOINING METHOD**

(30) Priority: 29.07.2016 JP 2016149295
(71) Applicant: Mitsubishi Heavy Industries Machine Tool Co., Ltd., Ritto-shi Shiga 5203080 (JP); National Institute Of Advanced Industrial Science, Tokyo 100-8921 (JP)
(72) Inventor: UTSUMI, Jun, Ritto-shi Shiga 520-3080 (JP); IDE, Kensuke, Ritto-shi Shiga 520-3080 (JP); SUZUKI, Takenori, Ritto-shi Shiga 520-3080 (JP); GOTO, Takayuki, Ritto-shi Shiga 520-3080 (JP); TAKAGI, Hideki, Tsukuba-shi Ibaraki 305-8564 (JP); KURASHIMA, Yuuichi, Tsukuba-shi Ibaraki 305-8564 (JP)
(74) Representative: Henkel, Breuer & Partner
(86) International application number: PCT/JP2017/018186
(87) International publication number: WO 2018/020780

(57) **Abstract**

Provided is a substrate joining method for joining a first substrate (11) and a second substrate (12) by sputter-etching, the substrate joining method comprising: an activation step in which the surface of a first substrate (11) is irradiated with a beam (2) of ion particles of a gas (1) such as Ar and sputter-etched to thereby attach sputtered particles (Ms) from the first substrate (11) onto the surface of a second substrate (12), the first substrate (11) comprising at least one among a semiconductor material, a compound semiconductor material, and a metal material; and a joining step in which the surface of the second substrate (12), onto which the sputtered particles (Ms) from the first substrate (11) are attached, and the surface of the substrate (11), which is sputter-etched, are overlapped and joined with each other.

## Description

### Technical Field

The present invention relates to a substrate bonding method of bonding a first substrate and a second substrate by sputter-etching.

### Background Art

For example, in the case where substrates made of a semiconductor material such as Si and Ge, a compound semiconductor material such as a Ga-based material and an In-based material, or a metal material such as Au, Cu, and Al are bonded to each other at room temperature; in conventional methods, the surface of each substrate is irradiated with a beam of ion particles in a vacuum environment to activate the surface of the substrate by sputter-etching, and these substrates are bonded to each other by bringing these surfaces into contact with each other.

### Citation List

### Patent Literature

Patent Literature 1: International Publication No. WO2012/105474

### Summary of Invention

### Technical Problem

However, for example, for substrates made of an amorphous oxide material such as amorphous SiO₂, an amorphous nitride material such as amorphous SiN, or the like, even when the surfaces of the substrates are sputter-etched by irradiating the surfaces with a beam of ion particles, the activity of the surfaces decreases rapidly. Thus, it is difficult to bond the substrates with a sufficient strength.

### Solution to Problem

A substrate bonding method according to a first aspect of the invention to solve the above problem is a substrate bonding method of bonding a first substrate and a second substrate by sputter-etching, characterized in that the first substrate is made of at least one of a semiconductor material, a compound semiconductor material, and a metal material, and the substrate bonding method comprises: an activation step of sputter-etching a surface of the first substrate by irradiating the surface of the first substrate with a beam of ion particles, to deposit sputtered particles of the first substrate on a surface of the second substrate; and a bonding step of bonding the second substrate and the first substrate by bringing the surface of the second substrate on which the sputtered particles of the first substrate have been deposited and the surface of the first substrate that have been sputter-etched into contact with each other.

A substrate bonding method according to a second aspect of the invention is the substrate bonding method according to the first aspect of the invention, characterized in that the substrate bonding method further comprises, before the activation step, a cleaning step of sputter-etching the surface of the second substrate by irradiating the surface of the second substrate with a beam of ion particles to clean the surface of the second substrate.

A substrate bonding method according to a third aspect of the invention is the substrate bonding method according to the first or second aspect of the invention, characterized in that the second substrate is made of at least one of an oxide material, a nitride material, a carbide material, a fluoride material, a semiconductor material, a compound semiconductor material, and a metal material.

### Advantageous Effects of Invention

In the substrate bonding method according to the present invention, the first substrate is made of at least one of a semiconductor material, a compound semiconductor material, and metal material. A surface of the first substrate is sputter-etched by irradiating the surface of the first substrate with a beam of ion particles, to deposit the sputtered particles of the first substrate on a surface of the second substrate. Then, the second substrate and the first substrate are bonded to each other by bringing the surface of the second substrate on which the sputtered particles of the first substrate has been deposited and the surface of the first substrate that has been sputter-etched into contact with each other. Consequently, for example, even though the second substrate is made of a material the activity of which tends to decrease, the second substrate can be bonded to the first substrate at room temperature with a high strength.

### Brief Description of Drawings

Fig. 1 is a diagram illustrating a schematic configuration of a substrate bonding apparatus used for explaining and implementing a procedure of a first embodiment of a substrate bonding method according to the present invention.
Fig. 2 is a diagram for explaining a procedure subsequent to Fig. 1.
Fig. 3 is a diagram for explaining a procedure subsequent to Fig. 2.
Fig. 4 is a diagram for explaining a procedure subsequent to Fig. 3.
Fig. 5 is a diagram illustrating a schematic configuration of a substrate bonding apparatus used for explaining and implementing a procedure of a second embodiment of a substrate bonding method according to the present invention.
Fig. 6 is a diagram for explaining a procedure subsequent to Fig. 5.
Fig. 7 is a diagram for explaining a procedure subsequent to Fig. 6.
Fig. 8 is a diagram for explaining a procedure subsequent to Fig. 7.
Fig. 9 is a diagram for explaining a procedure subsequent to Fig. 8.
Fig. 10A is a diagram for explaining the action in Fig. 1 and Fig. 6.
Fig. 10B is a diagram for explaining the action in Fig. 3 and Fig. 8.

### Description of Embodiments

Embodiments of substrate bonding methods according to the present invention will be described based on the drawings; however, the present invention is not limited only to the following embodiments described based on the drawings.

### <First Embodiment>

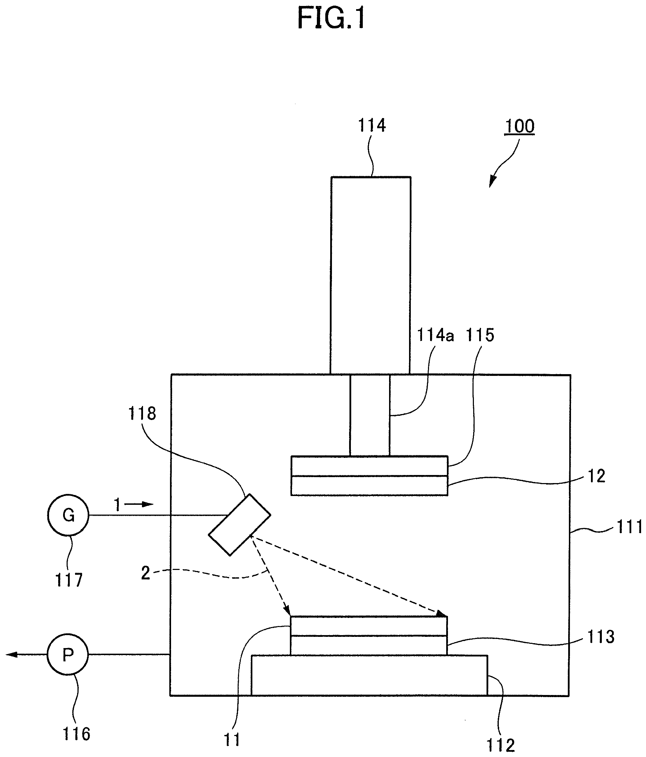

A first embodiment of a substrate bonding method according to the present invention will be described based on Figs. 1 to 4.

As illustrated in Fig. 1, at a lower center portion inside a chamber 111 is placed a support base 112. On the support base 112, a lower stage 113 is arranged so as to attachably and detachably hold a first substrate 11 on its upper surface. To the upper center portion of the ceiling of the chamber 111 is attached the distal end of a lifting cylinder 114 with its axial direction oriented in the up-down direction. The lifting cylinder 114 is configured to move the distal end of a rod 114a upward and downward inside the chamber 111. To the lower surface of the distal end of the rod 114a of the lifting cylinder 114 is attached an upper stage 115, which attachably and detachably holds a second substrate 12 under its lower surface.

To the chamber 111 is connected an exhaust pump 116 which evacuates the chamber 111 to make the inside a high vacuum environment. Inside the chamber 111 is arranged an ion gun 118, such as a FAB, to be oriented with its delivery port directed to a surface (upper surface) of the first substrate 11 held on the lower stage 113. The ion gun 118 is connected to a gas source 117 which supplies the ion gun 118 with gas 1, such as argon, as feedstock gas.

The first substrate 11 is made of at least one of a semiconductor material such as Si and Ge; a compound semiconductor material including a Ga based material such as GaN, GaAs, and GaP, and an In based material such as InP and InSb; and a metal material such as Au, Cu, and Al. On the other hand, the second substrate 12 is made of at least one of an amorphous oxide material such as amorphous SiO₂; an amorphous nitride material such as amorphous SiN; an amorphous carbide material such as amorphous SiC, and an amorphous fluoride material such as amorphous CaF₂.

Next, description will be provided for a substrate bonding method using the substrate bonding apparatus 100 according to this embodiment described above.

First, the first substrate 11 is attached to the lower stage 113, and the second substrate 12 is attached to the upper stage 115 (a substrate holding step) . Then, the exhaust pump 116 is operated to evacuate the chamber 111 to make the inside a high vacuum environment (an exhaust step).

Next, when the gas 1 is supplied for the ion gun 118 from the gas source 117 and the ion gun 118 is turned on, the ion gun 118 radiates a beam 2 of ion particles of the gas 1 toward the surface (upper surface) of the first substrate 11 on the lower stage 113 (see Fig. 1) .

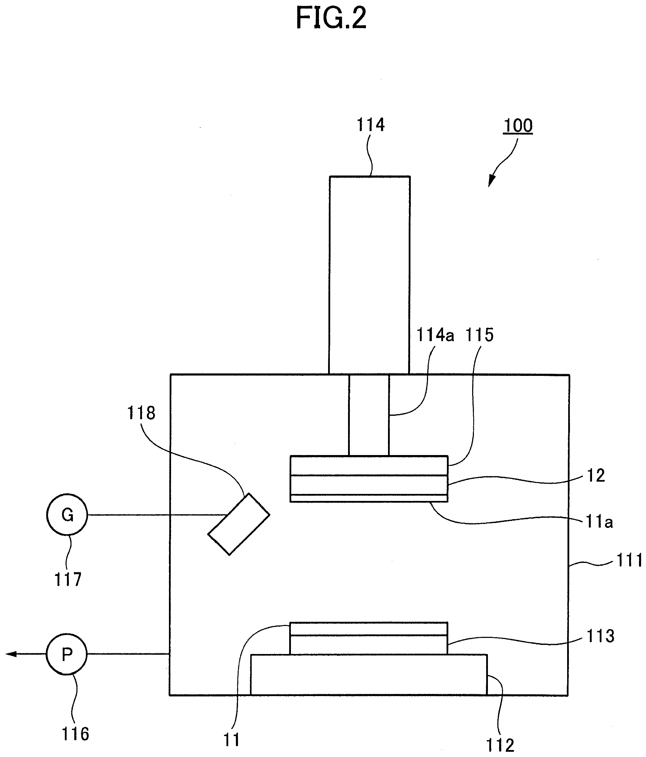

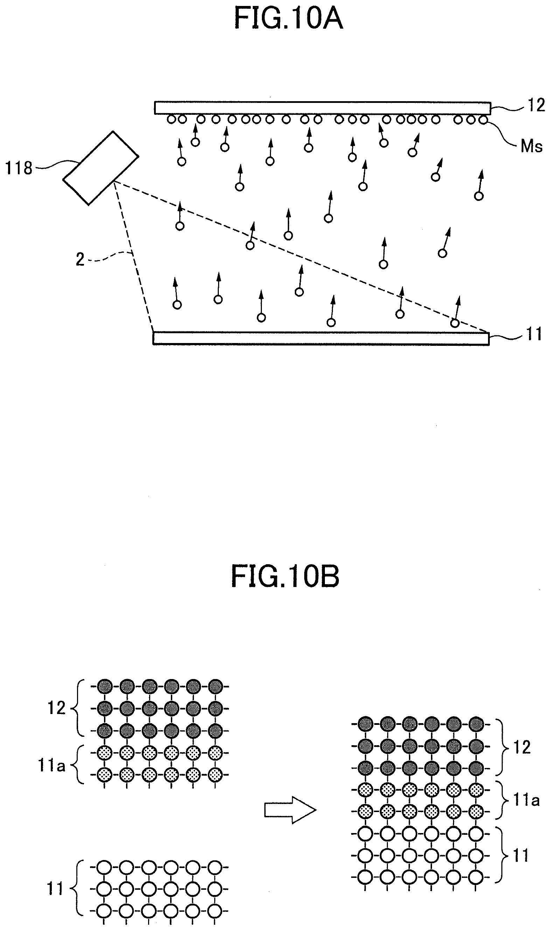

With this operation, the surface (upper surface) of the first substrate 11 made of a material described above is sputter-etched to be activated, and at the same time, sputtered particles Ms of a foregoing material of the first substrate 11 are attached to the surface (lower surface) of the second substrate 12 (see Fig. 10 A). Thus, an active layer 11a composed of the sputtered particles Ms of the foregoing material is formed so as to adhere to the surface (lower surface) of the second substrate 12 (see Fig. 2) (an activation step).

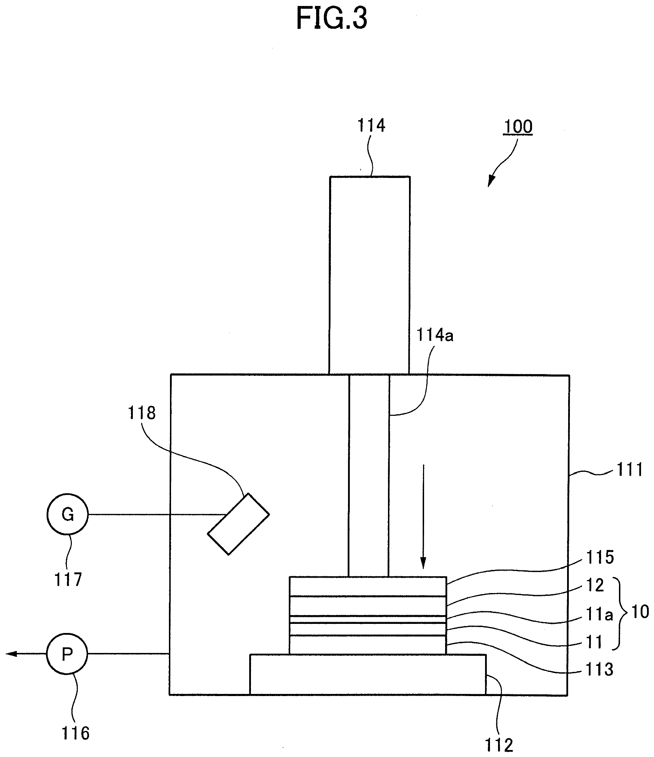

After the active layer 11a composed of the sputtered particles Ms of the material of the first substrate 11 is formed so to adhere to the surface (lower surface) of the second substrate 12 in this way, the operation of the ion gun 118 is stopped. Then, the lifting cylinder 114 is operated to extend the rod 114a and lower the upper stage 115, so that the lower stage 113 and the upper stage 115 are brought relatively close to each other in the opposing direction. The active layer 11a of the surface (lower surface) of the second substrate 12 held by the upper stage 115 is pressed against the activated surface (upper surface) of the first substrate 11 held by the lower stage 113 with these surfaces in contact with each other (see Fig. 3) . Thus, the first substrate 11 and the second substrate 12 are bonded to each other via the active layer 11a (see Fig. 10B) (a bonding step).

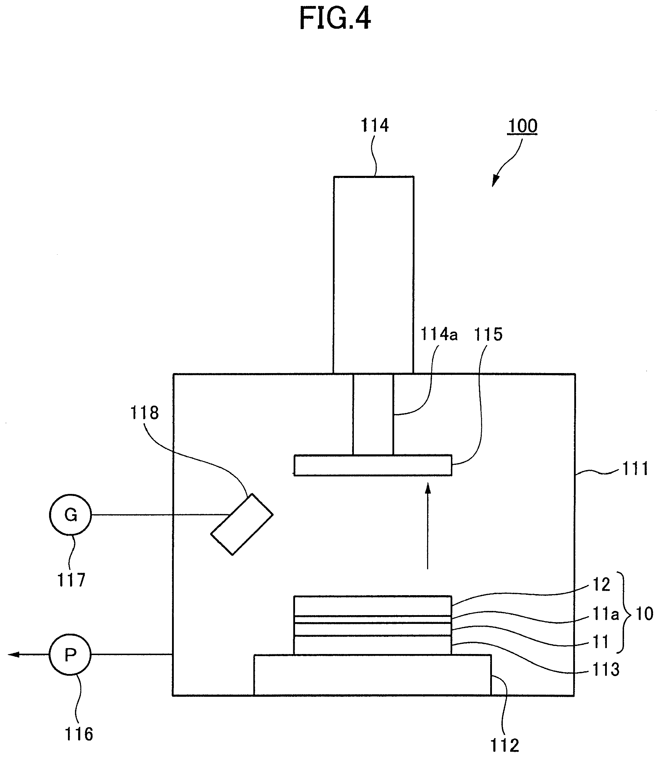

After the surface (upper surface) of the first substrate 11 is bonded to the surface (lower surface) of the second substrate 12 via the active layer 11a as described above, the upper stage 115 releases the holding of the second substrate 12. Then, the lifting cylinder 114 is operated to shorten the rod 114a to move the upper stage 115 upward, so that the lower stage 113 and the upper stage 115 relatively move apart from each other in the opposing direction. Thus, the upper stage 115 is disengaged from the second substrate 12 (see Fig. 4).

The operation of the exhaust pump 116 is stopped, and the pressure inside the chamber 111 is returned to the atmospheric pressure. Then, the lower stage 113 releases the holding of the first substrate 11. A bonded material 10 is obtained by taking it out from the position on the lower stage 113 to the outside of the chamber 111.

In summary, as described earlier, the beam 2 is radiated to the first substrate 11 made of the foregoing material to activate the surface of the first substrate 11 and also deposit the sputtered particles Ms of the first substrate 11 on the surface of the second substrate 12. Thus, the active layer 11a of the sputtered particles Ms is formed on the surface of the second substrate 12 made of a material the activity of which tends to decrease so as to adhere to it (the activation step). The activated surface of the first substrate 11 and the active layer 11a are pressed and bonded to each other (the bonding step). With these steps, the first substrate 11 is bonded to the second substrate 12 made of a material the activity of which tends to decrease in this embodiment.

As a result, in this embodiment, the second substrate 12 made of a material the activity of which tends to decrease can be bonded to the first substrate 11 at room temperature with high strength.

Thus, according to this embodiment, a bonded material 10 with a sufficient joint strength can be produced at room temperature using the second substrate 12 even made of a material the activity of which tends to decrease.

In addition, since radiating the beam 2 to the first substrate 11 activates the surface of the first substrate 11 and also attaches the sputtered particles Ms that occur from the first substrate 11 to the surface of the second substrate 12 so that the active layer 11a is formed so as to adhere to the surface of the second substrate 12, this eliminates the need for the dedicated material and process to form the active layer 11a and suppresses the increase in cost and time to produce the bonded material 10.

Here, Table 1 shows results of experiments conducted to confirm effects of the substrate bonding method according to this embodiment. Note that Table 1 also shows results of a conventional method which was conducted for comparison.

**[Table 1]**

| | This embodiment | Conventional method |
|---|---|---|
| First substrate | Si | Si |
| Second substrate | Amorphous SiO₂ | Amorphous SiO₂ |
| Gas | Ar | Ar |
| Beam radiation | To only the first substrate for 2.5 minutes | To both the first and second substrates for 2.5 minutes |
| Surface energy (J/mm²) | 1.3 | 0.3 |

As can be seen from the above Table 1, the surface energy of the bonded surface between the first substrate and the second substrate by the conventional method was only 0.3 J/m². On the other hand, it was confirmed that the surface energy in this embodiment was as much as 1.3 J/m², which is a practical value (1.0 J/m² or more).

### <Second Embodiment>

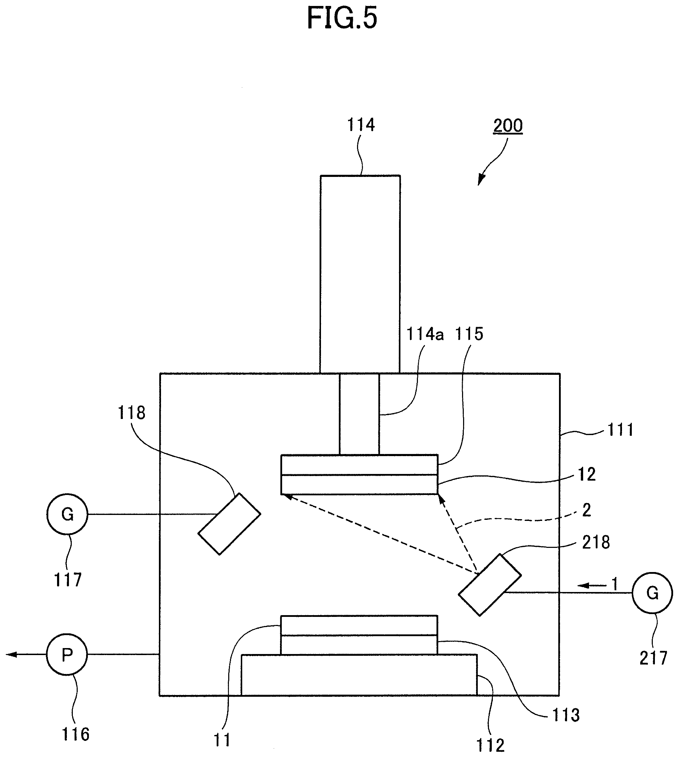

A second embodiment of a substrate bonding method according to the present invention will be described based on Figs. 5 to 9. Here, for the same parts as in the foregoing embodiment, the same reference signs as have been used in the description for the foregoing embodiment are used to omit explanation overlapped with the description for the foregoing embodiment.

As illustrated in Fig. 5, inside the chamber 111 is arranged an ion gun 218, such as a FAB, to be oriented with its delivery port directed to the surface (lower surface) of the second substrate 12 held by the upper stage 115. The ion gun 218 is connected to a gas source 217 which supplies the ion gun 218 with gas 1, such as argon.

Specifically, although in the foregoing embodiment, the ion gun 118 or other parts are arranged such that the beam 2 can be radiated to only the first substrate 11 held by the lower stage 113; in this embodiment, the ion gun 218 and other parts are also arranged such that the beam 2 can be radiated to the second substrate 12 held by the upper stage 115.

Next, description will be provided for a substrate bonding method using the substrate bonding apparatus 200 according to the embodiment described above.

First, as in the foregoing embodiment, a first substrate 11 is attached to the lower stage 113, and also a second substrate 12 is attached to the upper stage 115 (the substrate holding step). Then, the exhaust pump 116 is turned on to evacuate the chamber 111 and make the inside a high vacuum environment (the exhaust step).

Next, when the gas 1 is supplied to the ion gun 218 from the gas source 217, and the ion gun 218 is turned on, the ion gun 218 radiates a beam 2 of ion particles of the gas 1 toward the surface (lower surface) of the second substrate 12 under the upper stage 115 (see Fig. 5). With this operation, the surface (lower surface) of the second substrate 12 is sputter-etched and cleaned (a cleaning step).

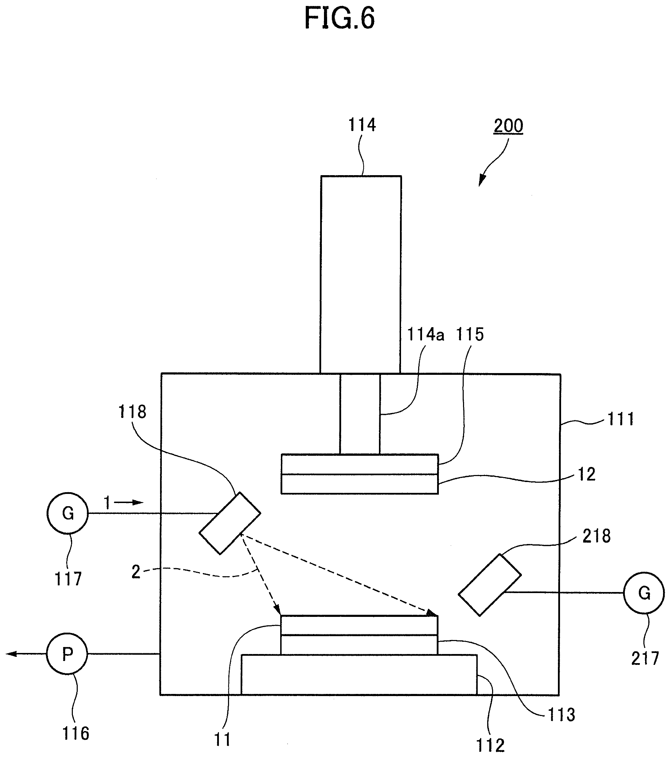

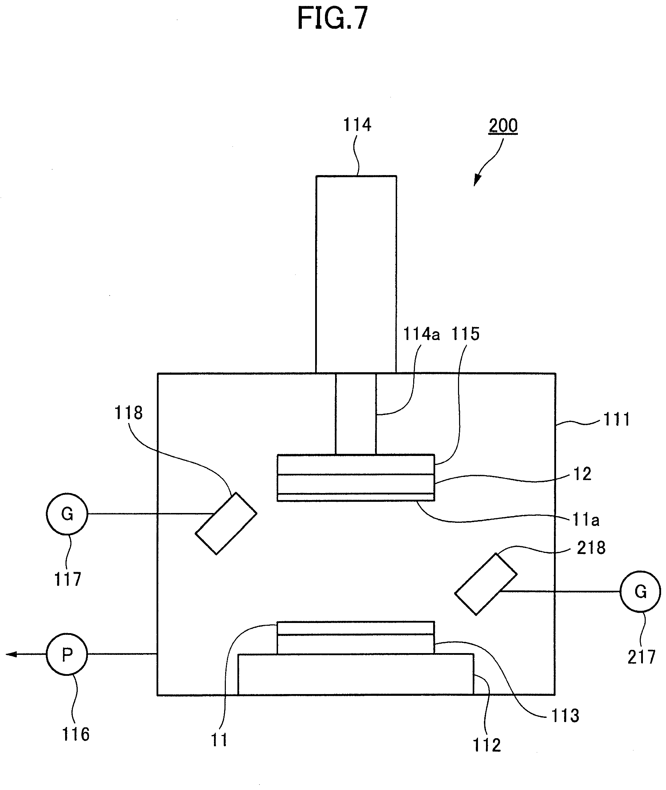

After the surface (lower surface) of the second substrate 12 is cleaned in this way, the operation of the ion gun 218 is stopped. Then, as in the foregoing embodiment, the gas source 117 supplies the gas 1 to the ion gun 118, and the ion gun 118 is turned on, so that the ion gun 118 radiates the beam 2 of ion particles of the gas 1 toward the surface (upper surface) of the first substrate 11 on the lower stage 113 (see Fig. 6). As in the foregoing embodiment, the surface of the first substrate 11 (upper surface) is sputter-etched and activated, and at the same time, the sputtered particles Ms of the first substrate 11 are deposited on the surface (lower surface) of the second substrate 12 (see Fig. 10A). With this operation, an active layer 11a composed of the sputtered particles Ms is formed on the surface (lower surface) of the second substrate 12 so as to adhere to it (see Fig. 7) (the activation step).

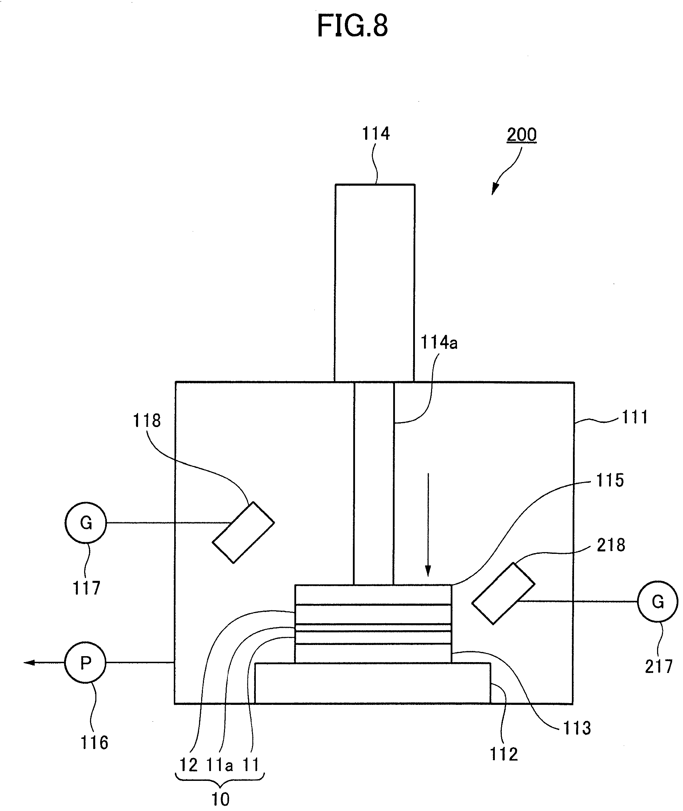

Next, as in the foregoing embodiment, after the operation of the ion gun 118 is stopped, the lifting cylinder 114 is operated so that the lower stage 113 and the upper stage 115 are brought relatively close to each other in the opposing direction. Then, the active layer 11a of the surface (lower surface) of the second substrate 12 held by the upper stage 115 is pressed against the activated surface (upper surface) of the first substrate 11 held by the lower stage 113 with these surfaces in contact with each other (see Fig. 8). Thus, the first substrate 11 and the second substrate 12 are bonded to each other via the active layer 11a (see Fig. 10B) (the bonding step).

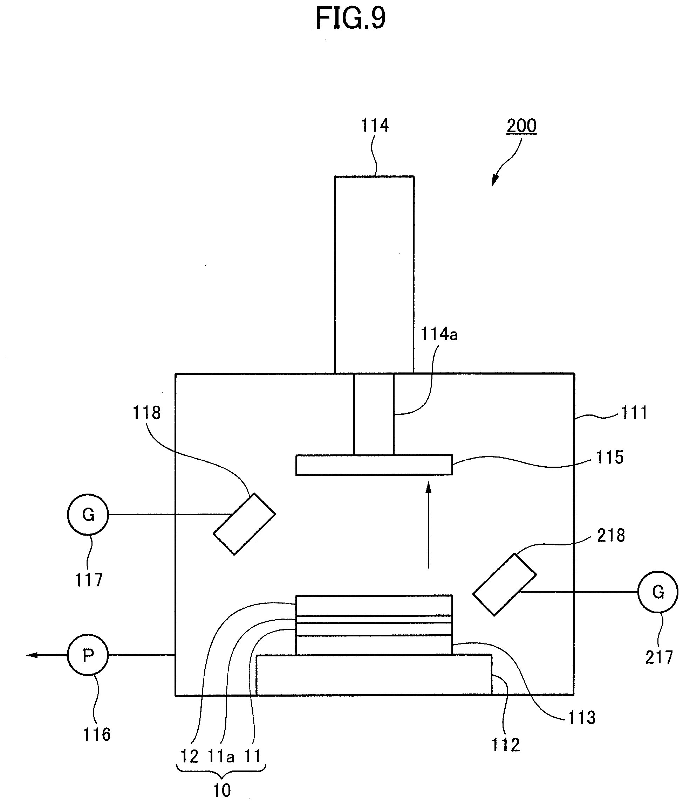

Next, as in the foregoing embodiment, the upper stage 115 releases the holding of the second substrate 12. Then, the lifting cylinder 114 is operated to move the upper stage 115 upward, so that the lower stage 113 and the upper stage 115 relatively move apart from each other in the opposing direction (see Fig. 9) . After that, the operation of the exhaust pump 116 is stopped, and the pressure inside the chamber 111 is returned to the atmospheric pressure. Then, the lower stage 113 releases the holding of the first substrate 11. A bonded material 10 is taken out from the position on the lower stage 113 to the outside of the chamber 111.

In summary, in this embodiment, the surface of the second substrate 12 is cleaned in advance by irradiating the second substrate 12 with the beam 2 and sputter-etching it, before the foregoing activation step in the foregoing embodiment is performed.

As result, in this embodiment, the adhesion of the active layer 11a to the surface (lower surface) of the second substrate 12 can be further increased, compared to the case in the foregoing embodiment.

Thus, this embodiment not only provides the same effect as in the foregoing embodiment as a matter of course but also provides a bonded material 10 with a bonding strength higher than the cases in the foregoing embodiment.

Note that in the activation step, in order to form an active layer 11a with a necessary and sufficient thickness (about 0.5 nm) on the surface of the second substrate 12 with the sputtered particles Ms from the first substrate 11, the first substrate 11 is irradiated with the beam 2 for necessary and sufficient time (for example, about 1 minute) . On the other hand, in the cleaning step, the second substrate 12 is irradiated with the beam 2 for necessary and sufficient time (for example, about 30 seconds) to remove contamination such as natural oxide film formed on the surface of the second substrate 12. Accordingly, this cleaning step does not activate the surface of the second substrate 12, unlike the activation step.

In addition, it is preferable that the distance between the first substrate 11 and the second substrate 12 in the opposing direction be large in the cleaning step so that the contamination such as natural oxide film removed from the surface of the second substrate 12 is less likely to be attached to the surface of the first substrate 11. In contrast, it is preferable that the distance between the first substrate 11 and the second substrate 12 in the opposing direction be small in the activation step to the extent where the radiation of the beam 2 to the first substrate 11 is not hindered so that the sputtered particles Ms from the first substrate 11 can be deposited on the surface of the second substrate 12 efficiently.

### <Other Embodiments>

Note that although in the foregoing first embodiment, the lower stage 113 holds the first substrate 11, while the upper stage 115 holds the second substrate 12, and the ion gun 118 is arranged such that the delivery port is directed to the first substrate 11 held by the lower stage 113; in another embodiment, the same effect as in the foregoing first embodiment can be obtained, for example, with the configuration in which the upper stage 115 holds the first substrate 11, while the lower stage 113 holds the second substrate 12, and the ion gun is arranged such that the delivery port is directed to the first substrate 11 held by the upper stage 115.

In addition, although the foregoing second embodiment includes two ion guns, the ion gun 118 oriented such that the delivery port is directed to the first substrate 11 held by the lower stage 113 and the ion gun 218 oriented such that the delivery port is directed to the second substrate 12 held by the upper stage 115; in another embodiment, the same effect as in the foregoing second embodiment can be obtained, for example, with the configuration including a single ion gun capable of changing the direction of the delivery port between to the first substrate 11 held by the lower stage 113 and to the second substrate 12 held by the upper stage 115.

In addition, although in the foregoing second embodiment, the lower stage 113 holds the first substrate 11, while the upper stage 115 holds the second substrate 12; in another embodiment, the same effect as in the foregoing second embodiment can be obtained, for example, with the configuration in which the upper stage 115 holds the first substrate 11, and the lower stage 113 holds the second substrate 12.

In addition, the foregoing embodiments have the configuration in which the lower stage 113 is arranged on the floor side of the chamber 111 via the support base 112, while the upper stage 115 is arranged on the ceiling side of the chamber 111 via the lifting cylinder 114, and the lower stage 113 and the upper stage 115 can be moved relatively close to or apart from each other in the opposing direction by the operation of the lifting cylinder 114. However, another embodiment can employ, for example, a configuration in which the lower stage 113 is arranged on the floor side of the chamber 111 via moving means capable of lifting up and down the lower stage 113, while the upper stage 115 is arranged on the ceiling side of the chamber 111 via a support member, and the lower stage 113 and the upper stage 115 can move relatively close to or apart from each other in the opposing direction by operating the moving means . Alternatively, another embodiment can employ, for example, a configuration in which the lower stage 113 is arranged on the floor side of the chamber 111 via first moving means capable of lifting up and down the lower stage 113, while the upper stage 115 is arranged on the ceiling side of the chamber 111 via second moving means capable of lifting up and down the upper stage 115, and the lower stage 113 and the upper stage 115 can move relatively close to or apart from each other in the opposing direction by operating the first and second moving means.

In addition, although in the foregoing embodiments, description has been provided for the cases where the second substrate 12 is made of at least one of an amorphous oxide material such as amorphous SiO₂, an amorphous nitride material such as amorphous SiN, an amorphous carbide material such as amorphous SiC, and an amorphous fluoride material such as amorphous CaF₂, the present invention is not limited to these materials. For example, the second substrate can be used in the same way as in the foregoing embodiments if the second substrate is made of at least one of materials including a crystalline oxide material such as crystalline SiO₂, a crystalline nitride material such as crystalline SiN, a crystalline carbide materials such as crystalline SiC, and a crystalline fluoride material such as crystalline CaF₂, and further including, in the same way as for the first substrate 11, a semiconductor material such as Si and Ge, a compound semiconductor material including a Ga based material such as GaN, GaAs, and GaP and an In based material such as InP and InSb, and a metal material such as Au, Cu, and Al.

However, it is much preferable that the second substrate 12 be made of at least one of an amorphous oxide material such as amorphous SiO₂, an amorphous nitride material such as amorphous SiN, an amorphous carbide material such as amorphous SiC, and an amorphous fluoride material such as amorphous CaF₂ as in the foregoing embodiments, because the substrate bonding method according to the present invention can utilized most effectively in these cases.

### Industrial Applicability

The substrate bonding method according to the present invention can be utilized very usefully from the industrial point of view because the second substrate can be bonded to the first substrate at room temperature with a high strength, for example, even if the second substrate is made of a material the activity of which tends to decrease.

### Reference Signs List

- 1: gas
- 2: beam
- 10: bonded material
- 11: first substrate
- 11a: active layer
- 12: second substrate
- 100, 200: substrate bonding apparatus
- 111: chamber
- 112: support base
- 113: lower stage
- 114: lifting cylinder
- 114a: rod
- 115: upper stage
- 116: exhaust pump
- 117, 217: gas source
- 118, 218: ion gun

## Claims

1. A substrate bonding method of bonding a first substrate and a second substrate by sputter-etching, **characterized in that**
the first substrate is made of at least one of a semiconductor material, a compound semiconductor material, and a metal material, and
the substrate bonding method comprises:
an activation step of sputter-etching a surface of the first substrate by irradiating the surface of the first substrate with a beam of ion particles, to deposit sputtered particles of the first substrate on a surface of the second substrate; and
a bonding step of bonding the second substrate and the first substrate by bringing the surface of the second substrate on which the sputtered particles of the first substrate have been deposited and the surface of the first substrate that have been sputter-etched into contact with each other.

2. The substrate bonding method according to claim 1, **characterized in that**
the substrate bonding method further comprises, before the activation step, a cleaning step of sputter-etching the surface of the second substrate by irradiating the surface of the second substrate with a beam of ion particles to clean the surface of the second substrate.

3. The substrate bonding method according to claim 1 or 2, **characterized in that**
the second substrate is made of at least one of an oxide material, a nitride material, a carbide material, a fluoride material, a semiconductor material, a compound semiconductor material, and a metal material.
